# EUROPEAN PATENT APPLICATION

(11) **EP 4 669 042 A1**
(43) Date of publication of application: **24.12.2025**
(21) Application number: 23922221.9
(22) Date of filing: 21.06.2023
(51) Int. Cl.: H05K 7/20, H05K 5/02

(54) **LIQUID COOLING CABINET, APPARATUS AND SYSTEM**

(30) Priority: 17.02.2023 CN 202320248556 U
(71) Applicant: Vertiv Corporation, Westerville, OH 43082 (US)
(72) Inventor: MA, Yuanbo, Xi'an, Shaanxi 710005 (CN); HUANG, Likui, Xi'an, Shaanxi 710005 (CN); XIE, Kai, Xi'an, Shaanxi 710005 (CN); CHENG, Yue, Xi'an, Shaanxi 710005 (CN); MENG, Lei, Xi'an, Shaanxi 710005 (CN); SU, Qi, Xi'an, Shaanxi 710005 (CN); WAN, Jiqing, Xi'an, Shaanxi 710005 (CN)
(74) Representative: Kilburn & Strode LLP
(86) International application number: PCT/CN2023/101633
(87) International publication number: WO 2024/169095

(57) **Abstract**

The present disclosure provides a liquid cooling cabinet, apparatus and system. The liquid cooling cabinet comprises a cabinet body, a liquid inlet pipe, a liquid outlet pipe, and at least one first guide pipe; a chamber configured to load a server and bear a cooling liquid is formed in the cabinet body; a liquid outlet is formed in the wall of the liquid inlet pipe, and the liquid inlet pipe is configured to supplement the cooling liquid for the chamber through the liquid outlet; one end of the first guide pipe is correspondingly connected to the liquid outlet, and the other end of the first guide pipe is configured to spray the cooling liquid; and the liquid outlet pipe is located inside the chamber and configured to discharge the cooling liquid. The cooling liquid is accurately sprayed to a determined position in the chamber of the liquid cooling cabinet by means of the first guide pipe, and additionally, the fluid disturbance effect of the cooling liquid in the chamber is enhanced, thereby improving the heat exchange efficiency.

## Description

This application claims the priority to Chinese Patent Application No. 202320248556.7, titled "LIQUID COOLING CABINET, APPARATUS AND SYSTEM", filed with the China National Intellectual Property Administration on February 17, 2023. All contents of the aforementioned application are incorporated herein by reference in its entirety.

### FIELD

The present disclosure relates to the technical field of big data, and in particular relates to a liquid cooling cabinet, a liquid cooling apparatus, and a liquid cooling system.

### BACKGROUND

With the rapid development of the internet industry, the requirements for data centers are getting higher and higher, wherein servers function as the core equipment of data centers and the power of the servers are getting higher and higher. To meet the cooling demands of high-load servers and achieve the standard for PUE (Power Usage Effectiveness), some services of the data centers need to be cooled down by adopting liquid cooling methods.

In related technologies, the basic principle of liquid cooling is to fill a cabinet (Tank) in which the servers are placed with coolant, so that the servers are immersed in the coolant. The heat generated by the servers is carried away by the continuous circulation of the coolant. In this method, however, when new coolant enters a cabinet filled with the coolant, the flow rate drops sharply, resulting in weak fluid disturbance effect, low turbulence, and consequently resulting in poor fluidity and low heat exchange efficiency, thus the servers cannot be cooled down quickly.

### SUMMARY

A liquid cooling cabinet, a liquid cooling apparatus, and a liquid cooling system are provided by the present disclosure to address the problems of low heat exchange efficiency in servers due to poor fluidity of the coolant in the cabinet in the prior art.

In a first aspect, a liquid cooling cabinet is provided by an embodiment of the present disclosure, the liquid cooling cabinet including a cabinet body, a liquid inlet pipe, a liquid outlet pipe, and at least one first guide pipe, wherein:
a chamber used to load a server and used to contain coolant is formed in the cabinet body;
a liquid outlet is disposed on a pipe wall of the liquid inlet pipe, and the liquid inlet pipe is used to supplement the coolant for the chamber through the liquid outlet;
for each of the first guide pipes, one end of the first guide pipe is correspondingly connected to the liquid outlet, and the other end of the first guide pipe is used to spray the coolant;
the liquid outlet pipe is located inside the chamber and is used to discharge the coolant.

A liquid cooling cabinet is provided by an embodiment of the present disclosure, the liquid cooling cabinet including a cabinet body, a liquid inlet pipe, a liquid outlet pipe, and at least one first guide pipe. A chamber used to load a server and used to contain coolant is formed in the cabinet body. A liquid outlet is disposed on a pipe wall of the liquid inlet pipe, and the liquid inlet pipe is used to supplement the coolant for the chamber through the liquid outlet; for each of the first guide pipes, one end of the first guide pipe is correspondingly connected to the liquid outlet, and the other end of the first guide pipe is used to spray the coolant. The liquid outlet pipe is located inside the chamber and is used to discharge the coolant. Through the first guide pipe, the coolant can be precisely sprayed into the chamber of the liquid cooling cabinet, which also enhances the fluid disturbance effect of the coolant within the chamber, thereby improving the heat exchange efficiency.

In an optional embodiment, the first guide pipe includes a first interface, a second interface, a first pipeline and a second pipeline, wherein:
one end of the first interface serves as one end of the first guide pipe, and the other end of the first interface is connected to one end of the second interface through the first pipeline;
the other end of the second interface is connected to one end of the second pipeline;
the other end of the second pipeline serves as the other end of the first guide pipe.

In the liquid cooling cabinet described above, the first guide pipe includes a first interface, a second interface, a first pipeline and a second pipeline. The first interface is used for connecting the corresponding liquid outlet of the first guide pipe and an end of the first pipeline, and the second interface is used for connecting another end of the first pipeline and an end of the second pipeline. The other end of the second pipeline is used for spraying the coolant. By splitting the first guide pipe into the first pipeline and the second pipeline and by connecting them through the first interface and the second interface, interference caused by connected pipelines is avoided, facilitating the disassembly of the first guide pipe.

In an optional embodiment, the second pipeline is provided with a spray nozzle opposite to a heat-generating component in the server;
the spray nozzle is used to spray the coolant to the heat-generating component.

In the liquid cooling cabinet described above, the second pipeline is provided with spray nozzles that are opposite to the heat-generating components in the server. The spray nozzles are used to spray the coolant onto the surface of the heat-generating components. By providing the spray nozzles on the second pipeline, the purpose of precisely delivering the coolant to the heat-generating components can be achieved. At the same time, the spray nozzles can accelerate the flow rate of the coolant, increase the liquid disturbance at the heat-generating components, and enhance heat exchange.

In an optional embodiment, at least one of the material of the first pipeline or the material of the second pipeline is flexible material.

In the liquid cooling cabinet described above, at least one of the material of the first pipeline or the material of the second pipeline is flexible material, such that the first guide pipe can be adjusted to the interior of the server and can also be adjusted to the exterior of the server, thereby enabling flexible adjustment of the coolant spray position to facilitate faster heat exchange.

In an optional embodiment, the liquid cooling cabinet further includes at least one second guide pipe;
for each of the second guide pipes, one end of the second guide pipe is correspondingly connected to the liquid outlet, and the other end of the second guide pipe is used for spraying the coolant.

The liquid cooling cabinet described above further includes at least one second guide pipe. One end of the second guide pipe is correspondingly connected to a liquid outlet, and the other end of the second guide pipe is used for spraying the coolant. The second guide pipe is used to spray the coolant flowing out of the liquid outlet of the liquid inlet pipe to a specific position to enhance the liquid disturbance effect in the chamber of the liquid cooling cabinet and strengthen heat exchange.

In an optional embodiment, the liquid inlet pipe is disposed at a first position, at the first position, when the chamber contains the coolant, the liquid inlet pipe is not submerged in the coolant.

In the liquid cooling cabinet described above, the liquid inlet pipe is located at a first position, at the first position, when the chamber contains the coolant, the liquid inlet pipe is not submerged in the coolant. Since the liquid inlet pipe is not submerged in the coolant, it facilitates inspection and maintenance of the liquid inlet pipe.

In an optional embodiment, the first position is inside the chamber.

In the liquid cooling cabinet described above, when the first position is inside the chamber, that is, the liquid inlet pipe is disposed inside the chamber and is located at a position above the maximum level of the coolant, such that the liquid inlet pipe is not submerged in the coolant, which facilitates future inspection and maintenance.

In an optional embodiment, the liquid inlet pipe is located near an inner wall on a first side of the cabinet body, and the liquid outlet pipe is located near an inner wall on a second side of the cabinet body, wherein the inner wall on the first side and the inner wall on the second side are opposite to each other.

In the liquid cooling cabinet described above, the liquid inlet pipe is located near an inner wall on a first side of the cabinet body, and the liquid outlet pipe is located near an inner wall on a second side of the cabinet body, wherein the inner wall on the first side and the inner wall on the second side are opposite to each other. By disposing the liquid inlet pipe and the liquid outlet pipe near the inner walls of different sides of the cabinet body respectively, it is convenient for the coolant to flow into the chamber through the liquid inlet pipe and it is convenient for the coolant which has conducted heat-exchanging with the server to flow out of the chamber through the liquid outlet pipe.

In an optional embodiment, the liquid outlet pipe is submerged in the coolant when the chamber contains the coolant.

In the liquid cooling cabinet described above, when the chamber contains the coolant, the liquid outlet pipe is submerged in the coolant, allowing the heat-exchanged coolant to flow out smoothly through the liquid outlet pipe.

In an optional embodiment, the height difference between the position of the liquid outlet pipe and the maximum level of the coolant is less than a first threshold.

In the liquid cooling cabinet described above, when the chamber contains the coolant, the liquid outlet pipe is submerged in the coolant, and the height difference between the position of the liquid outlet pipe and the maximum level of the coolant is less than a first threshold. That is, the liquid outlet pipe is disposed at a position near the maximum level of the coolant, allowing the heat-exchanged coolant to flow out smoothly through the liquid outlet pipe.

In an optional embodiment, when the chamber contains with the coolant, the height difference between the position of the liquid outlet pipe and the maximum level of the coolant is greater than a second threshold.

In the liquid cooling cabinet described above, when the chamber is contains the coolant, the liquid outlet pipe is submerged in the coolant, and the height difference between the position of the liquid outlet pipe and the maximum level of the coolant is greater than a second threshold. That is, the liquid outlet pipe is disposed at a position away from the maximum level of the coolant, allowing the heat-exchanged coolant to flow out smoothly through the liquid outlet pipe.

In an optional embodiment, the liquid cooling cabinet further includes at least one adjustable valve;
The adjustable valve is disposed at any liquid outlet; or
the adjustable valve is disposed between the first guide pipe and the liquid outlet; or
the adjustable valve is disposed between the second guide pipe and the liquid outlet.

The liquid cooling cabinet described above further includes at least one adjustable valve. The adjustable valve is disposed at any liquid outlet; or disposed between the first guide pipe and the liquid outlet; or disposed between the second guide pipe and the liquid outlet. By controlling the adjustable valve to open or close, the coolant at the liquid outlet of the liquid inlet pipe can be controlled to flow out or not to flow out, reducing the coolant flow rate, enhancing system stability, and achieving energy savings.

In a second aspect, a liquid cooling apparatus is provided by an embodiment of the present disclosure, the liquid cooling apparatus including a heat-exchange unit, a fluid distributor, and at least one liquid cooling cabinet as any one of the embodiments described in the first aspect, wherein:
the output end of the heat exchange unit is connected to the input end of the fluid distributor, the input end of the heat exchange unit is connected to the output end of the fluid distributor, and the heat exchange unit is used for heat exchange and cooling of the coolant, and delivers the cooled coolant to the fluid distributor;
the distribution output end of the fluid distributor is connected to the liquid inlet pipe of the liquid cooling cabinet, the distribution input end of the fluid distributor is connected to the liquid outlet pipe of the liquid cooling cabinet, and the fluid distributor is used for diverting the coolant and delivers the diverted coolant to the corresponding liquid cooling cabinet.

In a third aspect, a liquid cooling system is provided by the present disclosure, the liquid cooling system including the liquid cooling apparatus as described in the embodiments in the second aspect.

The technical effects, that may be achieved by the liquid cooling apparatus disclosed in the second aspect and the liquid cooling system disclosed in the third aspect, refer to the description of the technical effects that may be achieved by the first aspect or the various possible solutions in the first aspect as mentioned above, which will not be repeated herein.

### BRIEF DESCRIPTION OF THE DRAWINGS

In order to describe the technical solutions in the embodiments of the present disclosure more clearly, drawings referred to in the description of the embodiments are briefly described hereinafter. It is apparent that the drawings described below merely illustrate some of the embodiments of the present disclosure, and those skilled in the art may obtain additional drawings based on these drawings without paying any creative effort.
FIG. 1a is a schematic structural view of a cabinet-type immersion liquid cooling apparatus provided by the related technology;
FIG. 1b is a schematic structural view of another cabinet-type immersion liquid cooling apparatus provided by the related technology;
FIG. 2 is a schematic structural view of a liquid cooling cabinet provided by an embodiment of the present disclosure;
FIG. 3 is a schematic structural view of a first guide pipe provided by an embodiment of the present disclosure;
FIG. 4a is a schematic view of positions of a liquid inlet pipe and a liquid outlet pipe of a liquid cooling cabinet provided by an embodiment of the present disclosure;
FIG. 4b is a schematic view of positions of a liquid inlet pipe and a liquid outlet pipe of another liquid cooling cabinet provided by an embodiment of the present disclosure;
FIG. 5 is a schematic structural view of a liquid cooling apparatus provided by an embodiment of the present disclosure;
FIG. 6 is a working flow chart of a liquid cooling system provided by an embodiment of the present disclosure.

### DETAILED DESCRIPTION OF THE EMBODIMENTS

In order to make the objectives, technical solutions, and advantages of the present disclosure clearer, the present disclosure is further described in detail below in conjunction with accompanying drawings. Apparently, the described embodiments are only some embodiments, rather than all embodiments, of the present disclosure. Based on the embodiments of the present disclosure, all the other embodiments obtained by those skilled in the art without paying creative effort will fall within the scope of the present disclosure.

It should be noted that the terms such as "first", "second" and the like in the description, the claims and the drawings above of the present disclosure are only used to distinguish similar objects, rather than describe a particular or chronological order. It should be understood that the data used herein may be exchanged as appropriate, such that the embodiments of the present disclosure described herein can be implemented in an order other than the order shown or described herein. The implementations described in the following exemplary embodiments do not represent all implementations that are consistent with the present disclosure. On the contrary, they are merely examples of devices and methods that are consistent with some aspects of the present disclosure as described in detail in the appended claims.

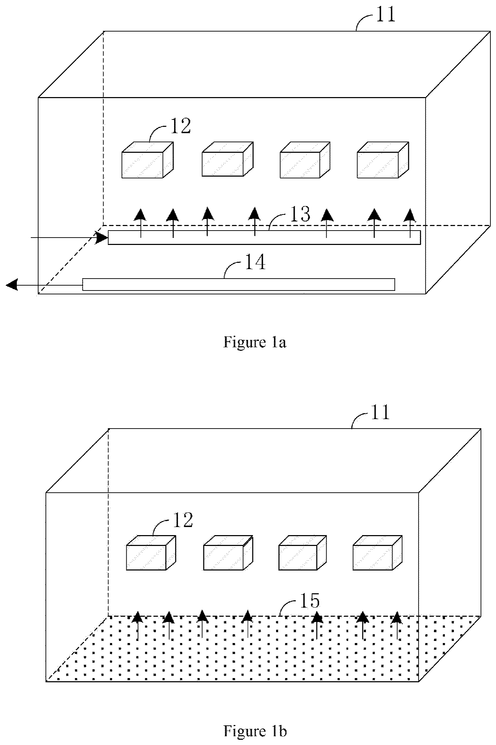

In related technologies, the structural views of a cabinet-type immersion liquid cooling apparatus are typically as shown in FIG. 1a and FIG. 1b. Specifically, as shown in FIG. 1a, the apparatus may include a cabinet 11, heat-generating components 12 placed inside the cabinet 11, and a liquid inlet pipe 13 and a liquid outlet pipe 14 provided at a bottom of the cabinet 11, wherein the coolant is introduced into the cabinet 11 through the liquid inlet pipe 13 and is sprayed upwards to the heat-generating components 12 to achieve the purpose of cooling the heat-generating components 12.

As shown in FIG. 1b, the apparatus may include a cabinet 11, heat-generating components 12 placed inside the cabinet 11, and a static pressure chamber 15 provided at the bottom of the cabinet 11, wherein the coolant is sprayed upwards to the heat-generating components 12 through the static pressure chamber 15 to achieve the purpose of cooling the heat-generating components 12.

In the above methods, however, when new coolant enters the cabinet filled with the coolant, the flow rate drops sharply, resulting in weak fluid disturbance effect, low turbulence, and consequently resulting in poor fluidity and low heat exchange efficiency, thus the servers cannot be cooled down quickly.

Based on this, the present disclosure provides a liquid cooling cabinet, a liquid cooling apparatus, and a liquid cooling system to enhance the fluidity of the coolant inside the cabinet and improve heat exchange efficiency.

The realization, functional features and advantages of the present disclosure will be further described with reference to the attached drawings and in combination with the embodiments. It can be understood that the specific embodiments described herein are only used to illustrate the present disclosure, and are not used to limit the present disclosure.

### Embodiment One

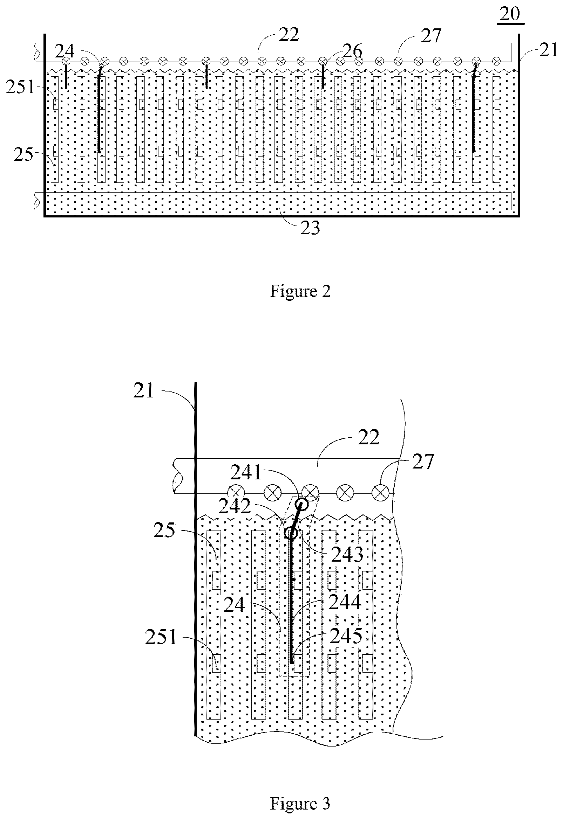

As shown in FIG. 2, a liquid cooling cabinet 20 is provided by an embodiment of the present disclosure, including a cabinet body 21, a liquid inlet pipe 22, a liquid outlet pipe 23, and at least one first guide pipe 24, wherein:
a chamber used to load a server 25 and used to contain coolant is formed in the cabinet body 21;
a liquid outlet is disposed on a pipe wall of the liquid inlet pipe 22, and the liquid inlet pipe 22 is used to supplement the coolant for the chamber through the liquid outlet;
for each of the first guide pipes 24, one end of the first guide pipe 24 is correspondingly connected to the liquid outlet, and the other end of the first guide pipe 24 is used to spray the coolant;
the liquid outlet pipe 23 is located inside the chamber and is used to discharge the coolant.

The liquid cooling cabinet 20 provided by an embodiment of the present disclosure includes a cabinet body 21, a liquid inlet pipe 22, a liquid outlet pipe 23, and at least one first guide pipe 24. A chamber used to load a server 25 and used to contain coolant is formed in the cabinet body 21. A liquid outlet is disposed on a pipe wall of the liquid inlet pipe 22, and the liquid inlet pipe 22 is used to supplement the coolant for the chamber through the liquid outlet. For each of the first guide pipes 24, one end of the first guide pipe 24 is correspondingly connected to the liquid outlet, and the other end of the first guide pipe 24 is used to spray the coolant. The liquid outlet pipe 23 is located inside the chamber and is used to discharge the coolant. Through the first guide pipe 24, the coolant can be precisely sprayed into the chamber of the liquid cooling cabinet 20, which also enhances the fluid disturbance effect of the coolant in the chamber and improves heat exchange efficiency.

It should be noted that the liquid cooling cabinet 20 in the embodiment of the present disclosure may be a horizontal cabinet, a vertical cabinet, or a wall-mounted cabinet, which will not be limited by the embodiment of the present disclosure.

The horizontal cabinet is described as an example in the following description.

In specific implementation, the liquid cooling cabinet 20 may include one first guide pipe 24 and may also include a plurality of first guide pipes 24. The number of the first guide pipe 24 can be specifically arranged based on the size of the liquid cooling cabinet 20, the number of server 25, and the actual operational requirement of the server 25. Specifically, the liquid inlet pipe 22 introduces the coolant, and a portion of the coolant is precisely delivered to the interior of any server 25 through the first guide pipe 24 which is correspondingly connected to the liquid outlet, improving the heat exchange efficiency of the heat-generating components inside the server 25. Another portion of the coolant is delivered into the chamber through the liquid outlet which is not connected to the first guide pipe 24, enhancing the flow effect of the coolant in the chamber to achieve the purpose of heat exchange and cooling for the servers. At the same time, the liquid outlet pipe 23 discharges the heated coolant.

In an embodiment of the present disclosure, the coolant is a non-conductive fluid medium. For example, the coolant may be synthetic oil and may also be fluorinated liquid products.

In one embodiment, as shown in FIG. 3, the first guide pipe 24 includes a first interface 241, a second interface 242, a first pipeline 243, and a second pipeline 244, wherein:
one end of the first interface 241 serves as one end of the first guide pipe 24, and the other end of the first interface 241 is connected to one end of the second interface 242 through the first pipeline 243;
the other end of the second interface 242 is connected to one end of the second pipeline 244;
the other end of the second pipeline 244 serves as the other end of the first guide pipe 24.

In specific implementation, the first guide pipe 24 includes a first interface 241, a second interface 242, a first pipeline 243, and a second pipeline 244, wherein as shown in FIG. 3, the second interface 242 is provided at a top interface of the server 25, dividing the first guide pipe 24 into two sections of pipeline, namely the first pipeline 243 and the second pipeline 244, for easy disassembly of the first guide pipe 24.

It should be noted that in an embodiment of the present disclosure, the first interface 241 and the second interface 242 may be quick interfaces and may also be detachable valve fittings, which will not be limited by the embodiment of the present disclosure.

In the liquid cooling cabinet 20 described above, the first guide pipe 24 includes a first interface 241, a second interface 242, a first pipeline 243, and a second pipeline 244. The first interface 241 is used to connect the corresponding liquid outlet of the first guide pipe 24 and one end of the first pipeline 243. The second interface 242 is used to connect the other end of the first pipeline 241 and one end of the second pipeline 244. The other end of the second pipeline 244 is used to spray the coolant. By splitting the first guide pipe 24 into the first pipeline 243 and the second pipeline 244 and connecting them through the first interface 241 and the second interface 242, interference caused by connected pipelines is avoided, facilitating the disassembly of the first guide pipe 24.

In one embodiment, as shown in FIG. 3, the second pipeline 244 is provided with spray nozzles 245 that are opposite to the heat-generating components 251 in the server 25;
the spray nozzles 245 are used to spray the coolant onto the heat-generating components 251.

In one embodiment, the spray nozzles 245 are provided in a one-to-one correspondence with the heat-generating components 251 in the server 25. That is, the number of spray nozzles 245 on the second pipeline 244 is equal to the number of heat-generating components 251 in the server 25 corresponding to the second pipeline 244. Therefore, each of the spray nozzles 245 may spray the coolant onto the surface of the heat-generating component 251 corresponding to it, accelerating the flow rate of the coolant at the heat-generating component 251, allowing the heat-generating component 251to cool down quickly, and enhancing the heat exchange effect.

In one embodiment, the spray nozzles 245 are arranged to be opposite to the heat-generating components 251 in the server 25, but the number of spray nozzles 245 on the second pipeline 244 is not equal to the number of heat-generating components 251 in the server 25 corresponding to the second pipeline 244. In this case, there are two scenarios.

### Scenario 1:

The number of spray nozzles 245 on the second pipeline 244 is less than the number of heat-generating components 251 in the server 25 corresponding to the second pipeline 244. In this case, the spray nozzles 245 on the second pipeline 244 rapidly spray the coolant to enhance the flow rate of the coolant inside the server 25 corresponding to the second pipeline 244, improving the heat exchange effect.

### Scenario 2:

The number of spray nozzles 245 on the second pipeline 244 is greater than the number of heat-generating components 251 in the server 25 corresponding to the second pipeline 244. In this case, the spray nozzles 245 on the second pipeline 244 can rapidly spray the coolant to achieve rapid cooling of the heat-generating components 251, significantly reducing the cooling time.

In the liquid cooling cabinet 20 described above, the second pipeline 244 is provided with spray nozzles 245 that are opposite to the heat-generating components 251 in the server 25. The spray nozzles 245 are used to spray the coolant onto the surface of the heat-generating components 251. By providing the spray nozzles 245 on the second pipeline 244, the purpose of precisely delivering the coolant to the heat-generating components 251 is achieved. At the same time, the spray nozzles 245 can accelerate the flow rate of the coolant, increase the liquid disturbance at the heat-generating components 251, and enhance heat exchange.

Optionally, at least one of the material of first pipeline 243 and the material of second pipeline 244 may be flexible material.

It should be noted that in an embodiment of the present disclosure, the first pipeline 243 and the second pipeline 244 may also be rigid, pre-fabricated pipelines, which will not be limited by the embodiment of the present disclosure.

In specific implementation, there are three scenarios regarding the material of the first pipeline 243 and the material of the second pipeline 244:
Scenario 1: both of the first pipeline 243 and the second pipeline 244 are metal hoses;
Scenario 2: the first pipeline 243 is a metal hose, and the second pipeline 244 is a rigid pipe;
Scenario 3: the first pipeline 243 is a rigid pipe, and the second pipeline 244 is a metal hose;

All of the three scenarios facilitate flexible adjustment of the coolant spray position.

As an example, the first pipeline 243 may be disposed outside the server 25, and the second pipeline 244 may be disposed inside the server 25. Therefore, the coolant may be directly delivered to the interior of the server through the first guide pipe 24, enhancing the fluid disturbance effect at the heat-generating components inside the server to achieve rapid cooling of the server.

As an example, the first pipeline 243 may be disposed outside the server 25, and the second pipeline 244 may be disposed in the gap between any two adjacent servers 25. Therefore, the coolant can be directly delivered to the vicinity of the server through the first guide pipe 24, enhancing the fluid disturbance effect at the server to achieve rapid cooling of the server.

In the liquid cooling cabinet described above, at least one of the material of first pipeline 243 and the material of second pipeline 244 is flexible material, such that the first guide pipe 24 can be adjusted to the interior of the server 25 and can also be adjusted to the exterior of the server 25, thereby enabling flexible adjustment of the coolant spray position to facilitate faster heat exchange.

In one embodiment, as shown in FIG. 2, the liquid cooling cabinet 20 further includes at least one second guide pipe 26;
for each of the second guide pipes 26, one end of the second guide pipe 26 is correspondingly connected to a liquid outlet, and the other end of the second guide pipe 26 is used for spraying the coolant.

In specific implementation, the liquid cooling cabinet 20 may include one second guide pipe 26 and may also include a plurality of second guide pipes 26. The number of second guide pipe 26 may be specifically arranged based on the size of the liquid cooling cabinet 20, the number of server 25, and the actual operational requirement of the server 25. Generally, the number of second guide pipe 26 is usually greater than one. Specifically, the liquid inlet pipe 22 introduces the coolant, and a portion of the coolant is delivered to the gap between any two adjacent servers 25 through the second guide pipe 26 which is correspondingly connected to the liquid outlet to increase the flow rate of the coolant at the servers 25. A portion of the coolant is delivered into the chamber through the liquid outlet which is not connected to the first guide pipe 24 to enhance the flow effect of the coolant in the chamber. Another portion of the coolant is precisely delivered to the interior of any one of the servers 25 through the first guide pipe 24 which is correspondingly connected to the liquid outlet to improve the heat exchange efficiency of the heat-generating components inside the server 25, achieving the purpose of heat exchange and cooling for the server.

The liquid cooling cabinet 20 described above further includes at least one second guide pipe 26. One end of the second guide pipe 26 is correspondingly connected to a liquid outlet, and the other end of the second guide pipe 26 is used for spraying the coolant. The second guide pipe 26 is used to spray the coolant flowing out of the liquid outlet of the liquid inlet pipe 22 to a specific position to enhance the liquid disturbance effect in the chamber of the liquid cooling cabinet 20 and strengthen heat exchange.

In an optional embodiment, the liquid inlet pipe 22 is disposed at a first position, at the first position, when the chamber contains the coolant, the liquid inlet pipe 22 is not submerged in the coolant.

In the liquid cooling cabinet 20 described above, the liquid inlet pipe 22 is disposed at a first position, at the first position, when the chamber contains coolant, the liquid inlet pipe 22 is not submerged in the coolant. Since the liquid inlet pipe 22 is not submerged in the coolant, it facilitates inspection and maintenance of the liquid inlet pipe 22.

In an optional embodiment, the first position is inside the chamber and is above the maximum level of the coolant.

In the liquid cooling cabinet 20 described above, when the first position is inside the chamber, that is, the liquid inlet pipe 22 is disposed inside the chamber and is located at a position above the maximum level of the coolant, such that the liquid inlet pipe 22 is not submerged in the coolant, which facilitates future inspection and maintenance.

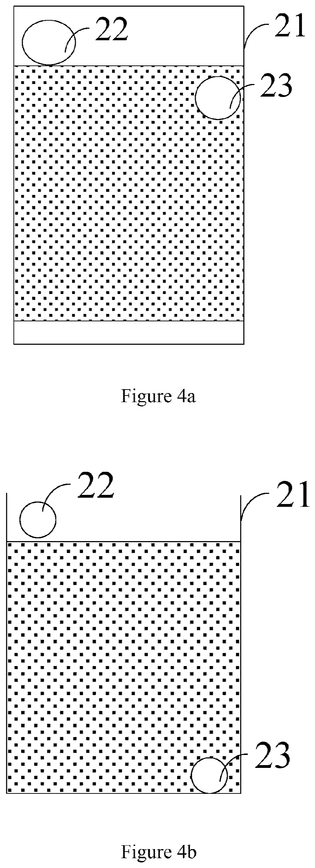

In an optional embodiment, as shown in FIGS. 4a and 4b, the liquid inlet pipe 22 is located near an inner wall of a first side of the cabinet body 21, and the liquid outlet pipe 23 is located near an inner wall of a second side of the cabinet body 21, wherein the inner wall of the first side and the inner wall of the second side are opposite to each other.

In an optional embodiment, as shown in FIGS. 4a and 4b, when the chamber contains the coolant, the liquid outlet pipe 23 is submerged in the coolant.

In the liquid cooling cabinet 20 described above, when the chamber contains the coolant, the liquid outlet pipe 23 is submerged in the coolant, allowing the heat-exchanged coolant to flow out smoothly through the liquid outlet pipe 23.

Optionally, as shown in FIG. 4a, the height difference between the position of the liquid outlet pipe 23 and the maximum level of the coolant is less than a first threshold.

In specific implementation, the liquid inlet pipe 22 is located at a position higher than the maximum level of the coolant and near the inner wall of the first side of the cabinet body 21. Since the liquid inlet pipe 22 is disposed at a position above the maximum level of the coolant, the liquid inlet pipe 22 is not submerged in the coolant, facilitating its future maintenance. When the chamber contains the coolant, the liquid outlet pipe 23 is submerged in the coolant, and the height difference between the position of the liquid outlet pipe 23 and the maximum level of the coolant is less than a first threshold, wherein the first threshold can be set based on the dimensions of the liquid cooling cabinet 20. That is, the liquid outlet pipe 23 is disposed at a position near the maximum level of the coolant and near the inner wall of the second side of the cabinet body 21, allowing the heat-exchanged coolant to flow out smoothly through the liquid outlet pipe 23.

Optionally, as shown in FIG. 4b, the height difference between the position of the liquid outlet pipe 23 and the maximum level of the coolant is greater than a second threshold.

In specific implementation, the liquid inlet pipe 22 is located at a position higher than the maximum level of the coolant and near the inner wall of the first side of the cabinet body 21. Since the liquid inlet pipe 22 is disposed at a position above the maximum level of the coolant, the liquid inlet pipe 22 is not submerged in the coolant, facilitating its future maintenance. When the chamber contains the coolant, the liquid outlet pipe 23 is submerged in the coolant, and the height difference between the position of the liquid outlet pipe 23 and the maximum level of the coolant is greater than a second threshold, wherein the second threshold can be set based on the dimensions of the liquid cooling cabinet 20. That is, the liquid outlet pipe 23 is disposed at a position away from the maximum level of the coolant and near the inner wall of the second side of the cabinet body 21, allowing the coolant to flow out smoothly through the liquid outlet pipe 23.

In the liquid cooling cabinet 20 described above, the liquid inlet pipe 22 is located near the inner wall of the first side of the cabinet body 21, and the liquid outlet pipe 23 is located near the inner wall of the second side of the cabinet body 21, wherein the inner wall of the first side and the inner wall of the second side are opposite to each other. By disposing the liquid inlet pipe 22 and the liquid outlet pipe 23 near the inner walls of different sides of the cabinet body 21 respectively, it is convenient for the coolant to flow into the chamber through the liquid inlet pipe 22 and it is convenient for the coolant which has conducted heat-exchanging with the server 25 to flow out of the chamber through the liquid outlet pipe 23.

In an embodiment, as shown in FIG. 2, the liquid cooling cabinet 20 further includes at least one adjustable valve 27;
the adjustable valve 27 is disposed at any liquid outlet; or
the adjustable valve 27 is disposed between the first guide pipe 24 and the liquid outlet; or
the adjustable valve 27 is disposed between the second guide pipe 26 and the liquid outlet.

It should be noted that in the embodiments of the present disclosure, the adjustable valve 27 may be a mechanical adjustable valve and may also be an electronic adjustable valve, which will not be limited by the embodiment of the present disclosure.

In specific implementation, an adjustable valve 27 may be disposed at any liquid outlet of the liquid inlet pipe 22, wherein some of these adjustable valves 27 are used to connect the liquid outlet corresponding to it and the first guide pipe 24. Specifically, the adjustable valve 27 connects the liquid outlet corresponding to it and the first interface 241 of the first guide pipe 24, facilitating the insertion, removal, and maintenance of the adjustable valve 27. The adjustable valve 27 is used to control the outflow of the coolant based on a first preset condition, such that the outflowing coolant is delivered to the corresponding heat-generating component 251 through the first guide pipe 24, enhancing the heat exchange effect. Some of the adjustable valves 27 are used to connect the liquid outlet corresponding to it and the second guide pipe 26. Specifically, the adjustable valves 27 connected to the second guide pipe 26 are generally kept open to allow the coolant to flow out through these adjustable valves 27, ensuring a minimum flow rate of the coolant in the liquid cooling system and enhancing system stability.

Specifically, based on the first preset condition, the adjustable valves 27 connected to the first guide pipe 24 are controlled to open or close. Optionally, the first preset condition may be: if the temperature at the heat-generating component 251 in the server 25 is detected to be greater than or equal to a first preset temperature, the adjustable valve 27 connected to the first guide pipe 24 is controlled to open; and if the temperature at the heat-generating component 251 in the server 25 is detected to be less than the first preset temperature, the adjustable valve 27 connected to the first guide pipe 24 is controlled to close, wherein the first preset temperature is determined based on the actual operational situation of the server 25 and is typically within the range of 50°C to 70°C. For example, the first preset temperature may be set to be 60°C.

In an embodiment, the first preset condition may be: if the temperature of the coolant in the chamber is detected to be greater than or equal to a second preset temperature, the adjustable valve 27 connected to the first guide pipe 24 is controlled to open; and if the temperature of the coolant in the chamber is detected to be less than the second preset temperature, the adjustable valve 27 connected to the first guide pipe 24 is controlled to close, wherein the second preset temperature is an empirical value, typically within the range of 35°C to 50°C. For example, the second preset temperature may be set to be 40°C.

In another embodiment, the first preset condition may be: if the difference between the temperature of the coolant flowing into the liquid inlet pipe and the temperature of the coolant flowing out of the liquid outlet pipe, i.e., the heat exchange temperature difference, is detected to be greater than or equal to a third preset temperature, the adjustable valve 27 connected to the first guide pipe 24 is controlled to close; and if the heat exchange temperature difference is detected to be less than the third preset temperature, the adjustable valve 27 connected to the first guide pipe 24 is controlled to open, wherein the third preset temperature is an empirical value. For example, the third preset temperature may be set to be 30°C.

Specifically, during the initial operation of the server 25, the heat generation of the heat-generating components 251 in the server 25 is relatively low due to a low load. Therefore, the adjustable valve 27 connected to the first guide pipe 24 is in a closed state to reduce the circulation of the coolant in the liquid cooling system, achieving the purpose of energy conservation.

The aforementioned liquid cooling cabinet 20 further includes at least one adjustable valve 27, which is disposed at any liquid outlet; or disposed between the first guide pipe 24 and the liquid outlet, or disposed between the second guide pipe 26 and the liquid outlet. By controlling the adjustable valve 27 to open or close, the coolant at the liquid outlet of the liquid inlet pipe 22 can be controlled to flow out or not to flow out, reducing the coolant flow rate, enhancing system stability, and achieving energy savings.

### Embodiment Two

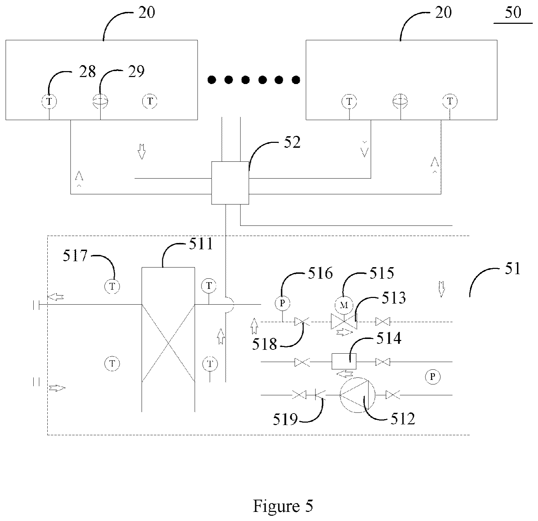

Based on the same concept, a liquid cooling apparatus is further provided by the present disclosure, as shown in FIG. 5. This liquid cooling apparatus 50 includes a heat exchange unit 51, a fluid distributor 52, and at least one liquid cooling cabinet 20 according to any of the aforementioned embodiments, wherein:
an output end of the heat exchange unit 51 is connected to an input end of the fluid distributor 52, and an input end of the heat exchange unit 51 is connected to an output end of the fluid distributor 52. The heat exchange unit 51 is used to cool the coolant through heat exchange and deliver the cooled coolant to the fluid distributor 52;
the distribution output end of the fluid distributor 52 is connected to the liquid inlet pipe of the liquid cooling cabinet 20, and the distribution input end of the fluid distributor 52 is connected to the liquid outlet pipe of the liquid cooling cabinet 20. The fluid distributor 52 is used to divert the coolant and delivers the diverted coolant to the corresponding liquid cooling cabinet 20.

It should be noted that in an embodiment of the present disclosure, the heat exchange unit 51 and the liquid cooling cabinet 20 may be an integrated unit and can also be separate units, which will not be limited by the embodiment of the present disclosure.

In specific implementation, as shown in FIG. 5, the heat exchange unit 51 includes a heat exchanger 511, a cooling pump 512, an adjustable valve 513, a system filter 514, a controller 515, a plurality of pressure sensors 516, a plurality of temperature sensors 517, a plurality of shut-off valves 518, and a check valve 519, wherein a primary side of the heat exchanger 511 is connected to a cooling device (not shown in the figure) and an output end of a temperature sensor 517 respectively. As an example, the cooling device may be a cooling tower, a dry cooler, a cold water chiller and the like. An output end of secondary side of the heat exchanger 511 serves as an output end of the heat exchange unit 51 and is connected to the input end of the fluid distributor 52 and is also connected to the output end of the temperature sensor 517 for delivering the coolant to the fluid distributor 52. An input end of the secondary side of the heat exchanger 511 is connected to the output end of the cooling pump 512, the input end of the adjustable valve 513, and the output end of the system filter 514 through different shut-off valves 518 respectively, and is also connected to the output end of a temperature sensor 517 for introducing heat-exchanged coolant. The heat exchanger 511 is specifically used for heat exchange between the primary side and the secondary side.

It should be noted that in an embodiment of the present disclosure, the heat exchanger 511 may be a shell-and-pipe heat exchanger and may also be a plate heat exchanger, which will not be limited by the embodiment of the present disclosure.

The input end of the cooling pump 512 is connected to the output end of the fluid distributor 52 through a shut-off valve 518, and is also connected to the output end of a pressure sensor 516. The output end of the cooling pump 512 is connected to the shut-off valve 518 through a check valve 519. The cooling pump 512 is used to adjust its rotation speed based on the pressure difference between its input and output ends, or based on the temperature of the secondary side of the heat exchanger 511, to change the driving force of the coolant circulation.

It should be noted that in an embodiment of the present disclosure, the number of cooling pump 512 may be one and may also be more than one, which will not be limited by the embodiment of the present disclosure. Furthermore, the cooling pump 512 in the embodiment of the present disclosure is a variable speed pump.

The input end of the adjustable valve 513 is connected to the shut-off valve 518 and the output end of the pressure sensor 516 respectively. The output end of the adjustable valve 513 is connected to the output end of the fluid distributor 52 through the shut-off valve 518. The control end of the adjustable valve 513 is connected to the output end of the controller 515. The adjustable valve 513 is used to regulate the flow rate of the coolant. As an example, the opening of the adjustable valve 513 may be configured in a standard manner and may also be configured selectively in combination with the driving force range of the cooling pump 512, which will not be limited by the embodiment of the present disclosure.

As an example, the rotation speed of the cooling pump 512 may be self-adaptively adjusted based on the pressure difference ΔP between its input and output ends and the opening of the adjustable valve 513 affects the magnitude of the pressure difference ΔP. Generally, the range of the pressure difference ΔP that allows the cooling pump 512 to operate normally is 0.8 bar to 3 bar.

In specific implementation, the adjustable valve 513 is set to be in a closed state, the adjustable valve connected to the second guide pipe is in a continuously open state, and the adjustable valve connected to the first guide pipe is in a closed state; at the initial stage of operation, although some of the adjustable valves are in a closed state, since the flow rate of the coolant required by the cabinet is greatly small, when the rotation speed of the cooling pump 512 is minimum rotation speed, the pressure difference ΔP is still too high, causing the cooling pump 512 to malfunction. At this time, the rotation speed of the cooling pump 512 should be reduced first, and then the adjustable valve 513 is opened to assist the cooling pump 512 to regulate the coolant flow rate, so that both the pressure difference ΔP and the rotation speed of the cooling pump 512 can be within the normal operating range; after operating for a period of time, the servers generate significant heat, and the coolant flow rate required by the cabinet increases significantly. It is necessary to appropriately increase the pressure difference ΔP of the cooling pump 512. At this time, the adjustable valve 513 should be closed first, and then the rotation speed of the cooling pump 512 is appropriately increased to increase the coolant flow rate.

The input end of the system filter 514 is connected to the output end of the fluid distributor 52 through the shut-off valve 518, and the output end of the system filter 514 is connected to the shut-off valve 518. The system filter 514 is used to filter the incoming coolant to ensure the cleanliness and chemical stability of the coolant.

In the embodiments of the present application, the number of liquid cooling cabinets 20 connected to the heat exchange unit 51 is determined based on actual operational requirement and its number is not limited. Generally, one heat exchange unit 51 may be connected to two liquid cooling cabinets 20 through a fluid distributor 52, and one heat exchange unit 51 may be connected to six liquid cooling cabinets 20 through a fluid distributor 52.

Furthermore, since this liquid cooling apparatus is the apparatus corresponding to the liquid cooling cabinet in the embodiments of the present disclosure, and the principle by which this liquid cooling apparatus solves problems is similar to that of the liquid cooling cabinet, the implementation of this liquid cooling apparatus can refer to the implementation of the liquid cooling cabinet, which will not be repeated herein.

### Embodiment Three

Based on the same concept, a liquid cooling system is further provided by an embodiment of the present disclosure, including at least one server and the liquid cooling apparatus according to any one of the above embodiments.

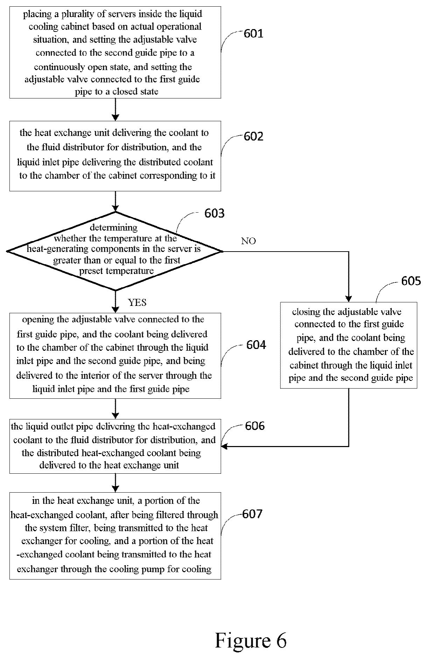

In specific implementation, the working flowchart of the liquid cooling system is as shown in FIG. 6, including the following steps:
S601: placing a plurality of servers inside the liquid cooling cabinet based on actual operational situation, and setting the adjustable valve connected to the second guide pipe to a continuously open state, and setting the adjustable valve connected to the first guide pipe to a closed state;
S602: the heat exchange unit delivering the coolant to the fluid distributor for distribution, and the liquid inlet pipe delivering the distributed coolant to the chamber of the cabinet corresponding to it;
S603: determining whether the temperature at the heat-generating components in the server is greater than or equal to the first preset temperature, if yes, proceed to S604, and otherwise, proceed to S605;
S604: opening the adjustable valve connected to the first guide pipe, and the coolant being delivered to the chamber of the cabinet through the liquid inlet pipe and the second guide pipe, and being delivered to the interior of the server through the liquid inlet pipe and the first guide pipe;
S605: closing the adjustable valve connected to the first guide pipe, and the coolant being delivered to the chamber of the cabinet through the liquid inlet pipe and the second guide pipe;
S606: the liquid outlet pipe delivering the heat-exchanged coolant to the fluid distributor for distribution, and the distributed heat-exchanged coolant being delivered to the heat exchange unit;
S607: in the heat exchange unit, a portion of the heat-exchanged coolant, after being filtered through the system filter, being transmitted to the heat exchanger for cooling, and a portion of the heat-exchanged coolant being transmitted to the heat exchanger through the cooling pump for cooling.

Since the liquid cooling system is the system corresponding to the liquid cooling cabinet in the embodiments of the present disclosure, and the principle by which the liquid cooling system solves problems is similar to that of the liquid cooling cabinet, the implementation of the liquid cooling system may refer to the implementation of the liquid cooling cabinet, which will not be repeated herein.

Those skilled in the art may make various modifications and variations to the present disclosure without departing from the principle of the present disclosure. In this way, if these modifications and variations fall within the scope of the claims and equivalents thereof, these modifications and variations are intended to be included in the present disclosure.

## Claims

1. A liquid cooling cabinet, **characterized by** comprising a cabinet body, a liquid inlet pipe, a liquid outlet pipe, and at least one first guide pipe, wherein:
a chamber used to load a server and used to contain coolant is formed in the cabinet body;
a liquid outlet is provided on a pipe wall of the liquid inlet pipe, and the liquid inlet pipe is used to supplement the coolant for the chamber through the liquid outlet;
for each of the first guide pipes: one end of the first guide pipe is correspondingly connected to the liquid outlet, and the other end of the first guide pipe is used to spray the coolant;
the liquid outlet pipe is located inside the chamber and is used to discharge the coolant.

2. The liquid cooling cabinet according to claim 1, **characterized in that** the first guide pipe comprises a first interface, a second interface, a first pipeline, and a second pipeline, wherein:
one end of the first interface serves as one end of the first guide pipe, and the other end of the first interface is connected to one end of the second interface through the first pipeline;
the other end of the second interface is connected to one end of the second pipeline;
the other end of the second pipeline serves as the other end of the first guide pipe.

3. The liquid cooling cabinet according to claim 2, **characterized in that** the second pipeline is provided with a spray nozzle opposite to a heat-generating component in the server;
the spray nozzle is used to spray the coolant to the heat-generating component.

4. The liquid cooling cabinet according to claim 3, **characterized in that** at least one of material of the first pipeline or material of the second pipeline is flexible material.

5. The liquid cooling cabinet according to claim 1, **characterized by** further comprising at least one second guide pipe,
wherein, for each of the second guide pipes: one end of the second guide pipe is correspondingly connected to the liquid outlet, and the other end of the second guide pipe is used for spraying the coolant.

6. The liquid cooling cabinet according to claim 1, **characterized in that** the liquid inlet pipe is disposed at a first position, at the first position, when the chamber contains the coolant, the liquid inlet pipe is not submerged in the coolant.

7. The liquid cooling cabinet according to claim 6, **characterized in that** the first position is inside the chamber.

8. The liquid cooling cabinet according to claim 7, **characterized in that** the liquid inlet pipe is located near an inner wall on a first side of the cabinet body, and the liquid outlet pipe is located near an inner wall on a second side of the cabinet body, wherein the inner wall on the first side and the inner wall on the second side are opposite to each other.

9. The liquid cooling cabinet according to claim 8, **characterized in that** the liquid outlet pipe is submerged in the coolant when the chamber contains the coolant.

10. The liquid cooling cabinet according to claim 9, **characterized in that** the height difference between the position of the liquid outlet pipe and the maximum level of the coolant is less than a first threshold.

11. The liquid cooling cabinet according to claim 9, **characterized in that** the height difference between the position of the liquid outlet pipe and the maximum level of the coolant is greater than a second threshold.

12. The liquid cooling cabinet according to any one of claims 1 to 11, **characterized by** comprising at least one adjustable valve, wherein:
the adjustable valve is disposed at any liquid outlet; or
the adjustable valve is disposed between the first guide pipe and the liquid outlet; or
the adjustable valve is disposed between the second guide pipe and the liquid outlet.

13. A liquid cooling apparatus, **characterized by** comprising a heat exchange unit, a fluid distributor, and at least one liquid cooling cabinet according to any one of claims 1 to 12, wherein:
an output end of the heat exchange unit is connected to an input end of the fluid distributor, an input end of the heat exchange unit is connected to an output end of the fluid distributor, and the heat exchange unit is used for heat exchange and cooling of the coolant, and delivers the cooled coolant to the fluid distributor;
a distribution output end of the fluid distributor is connected to the liquid inlet pipe of the liquid cooling cabinet, a distribution input end of the fluid distributor is connected to the liquid outlet pipe of the liquid cooling cabinet, and the fluid distributor is used for diverting the coolant and delivers the diverted coolant to the corresponding liquid cooling cabinet.

14. A liquid cooling system, **characterized by** comprising the liquid cooling apparatus according to claim 13.
